(19) Europäisches Patentamt
European Patent Office
Office européen des brevets

(11) **EP 2 369 637 B1**

(12) **EUROPEAN PATENT SPECIFICATION**

(45) Date of publication and mention
of the grant of the patent:
**26.02.2014  Bulletin 2014/09**

(51) Int Cl.:
**B32B 27/20** *(2006.01)*      **B32B 27/22** *(2006.01)*
**B32B 27/28** *(2006.01)*      **H01L 31/048** *(2014.01)*

(21) Application number: **09831884.3**

(22) Date of filing: **08.12.2009**

(86) International application number:
**PCT/JP2009/070502**

(87) International publication number:
**WO 2010/067780 (17.06.2010 Gazette 2010/24)**

(54) **FILM FOR SEALING BACK SIDE OF SOLAR CELL, MATERIAL FOR SEALING BACK SIDE OF SOLAR CELL, AND SOLAR CELL MODULE**

FOLIE ZUR RÜCKSEITIGEN VERSIEGELUNG EINER SOLARZELLE, MATERIAL ZUR RÜCKSEITIGEN VERSIEGELUNG EINER SOLARZELLE UND SOLARZELLENMODUL

FILM PERMETTANT DE SCELLER LE CÔTÉ ARRIÈRE D'UNE PILE SOLAIRE, MATÉRIAU PERMETTANT DE SCELLER LE CÔTÉ ARRIÈRE D'UNE PILE SOLAIRE ET MODULE DE PILE SOLAIRE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **12.12.2008  JP 2008316534**

(43) Date of publication of application:
**28.09.2011  Bulletin 2011/39**

(73) Proprietor: **Toray Industries, Inc.**
**Tokyo, 103-8666 (JP)**

(72) Inventors:
• **ARAI, Takashi**
**Otsu-shi**
**Shiga 520-8558 (JP)**
• **KAMEDA, Shunsuke**
**Otsu-shi**
**Shiga 520-8558 (JP)**
• **NAKAJIMA, Ayuko**
**Otsu-shi**
**Shiga 520-8558 (JP)**
• **NOGUCHI, Masakazu**
**Tokyo 103-8666 (JP)**
• **HIROTA, Kusato**
**Otsu-shi**
**Shiga 520-8558 (JP)**

(74) Representative: **Schaeberle, Steffen et al**
**Hoefer & Partner**
**Patentanwälte**
**Pilgersheimer Strasse 20**
**81543 München (DE)**

(56) References cited:
EP-A1- 1 637 565      JP-A- 2002 090 515
JP-A- 2004 247 390    JP-A- 2006 179 557
JP-A- 2006 319 250    JP-A- 2008 028 294
JP-A- 2009 246 360

## Description

Technical field

The invention relates to a film for solar battery backside sealing component comprising a pigmented layer that has high light resistance and moist heat resistance to serve for long term use in a harsh outdoor environment, as well as good decorative properties and high adhesion strength to silicone resin for bonding to terminal boxes that is required when used as outermost layer, and also relates to a solar battery backside sealing component and a solar battery module produced thereof.

Background art

In recent years, there has been greater fear for the depletion of fossil fuels including oil and coal, and there is pressing need to develop alternative energy sources to these fossil fuels. Accordingly, various methods for nuclear power generation, hydraulic power generation, wind power generation, and photovoltaic power generation have been studied, and some have been in actual use. Photovoltaic power generation, which can convert the energy of sunlight directly into electric energy, has been put to practical use as a new, pollution-free energy source that will be available virtually permanently. Its cost performance in practical use has been improved rapidly, making it a promising clean energy source.

Solar batteries used for photovoltaic power generation, which convert the energy of sunlight directly into electric energy, serve as the core portion of photovoltaic power generation systems, and they are made of semiconductors such as silicon. With respect to their structure, solar cell elements are arranged in series and/or in parallel and packaged in various ways into a unit to protect the elements for a time of 20 years or so. This packaged unit, which is called solar cell module, generally consists of a glass layer to cover the face that receives sunlight, a filler of thermoplastic resin to fill gaps, and a sealing sheet to protect the backside surface. For the thermoplastic resin filler, ethylene vinyl acetate copolymer resin (hereafter, EVA resin) is commonly used as they are high in transparency and moisture resistance. The backside sealing material, on the other hand, is not only required to have characteristics such as mechanical strength, weather resistance, heat resistance, water resistance, chemical resistance, light reflectivity, moisture barrier properties, thermal adhesion properties for bonding to EVA resin and other filler materials, decorative properties, and adhesion strength to outermost silicone resin layer for bonding to terminal boxes, but also need to have high light resistance because it is exposed to ultraviolet rays.

The materials conventionally used for films for backside sealing components include white polyvinyl fluoride film (trade name: Tedlar (registered trademark), supplied by Du Pont Kabushiki Kaisha), and laminate-type backside sealing components consisting of a polyester film sandwiched between the above-mentioned films have been widely used for the present purpose. A light resistant film produced by coating one or both surfaces of a polyester film with acrylic resin containing an ultraviolet absorber and photostabilization agent (Patent document 1), and a polyester film containing kneaded weather resistant agents (ultraviolet absorber, photostabilization agent, etc.) have also been proposed and put to practical use. White films produced from a layer produced by kneading white pigments such as titanium oxide into a polyester film have also been put to practical use, and they are known to have light resistance from the viewpoint of little change in appearance caused by exposure to ultraviolet rays (Patent document 2).

Prior art documents .

Patent documents

Patent document 1: Japanese Unexamined Patent Publication (Kokai) No. 2005-015557
Patent document 2: Japanese Unexamined Patent Publication (Kokai) No. HEI-11-291432

Disclosure of the invention

Problems to be solved by the invention

However, though said polyvinyl fluoride films are highly weather resistant, they are low in mechanical strength, and can be softened by the heat of 140 to 150°C applied during hot pressing for producing a solar cell module to allow projections in the electrodes of solar battery elements to penetrate the filler layer. Being high in price, furthermore, it is difficult to produce low-price solar cell modules comprising these films. As described in Patent document 2, in the case of a film coated with acrylic resin containing an ultraviolet absorber and a photostabilizing agent, the coat film should be relatively thick with a dry film weight of 5 g/m$^2$ or so to develop light resistance. To produce a white or colored film to provide backside sealing materials, it is necessary to use a relatively expensive colored film. As described in Patent document 2, furthermore, white films produced by kneading with white pigments can have some degree of UV resistance because the pigments have some light absorptive capacity to prevent the film appearance from being affected by ultraviolet irradiation. However, the resin, which is the primary component, does not have light resistance and has the problem of being gradually degraded in its own film characteristics such as breaking strength and rupture elongation when irradiated with ultraviolet rays.

As active efforts have been made to develop longer-life solar battery modules in recent years, solar cell modules are often installed obliquely from the ground in some areas including Europe. In such cases, they are exposed to ultraviolet rays reflected from the ground for a long period of time. Consequently, if the backside sealing component does not have a layer with a long-term stable light resistance to cover its outmost layer, it may be yellowed, causing deterioration in the appearance of the film, and in some cases, cracking may take place in the sealing component, causing deterioration in various other characteristics including electrical insulating properties and moisture barrier properties required for the sheet.

Means of solving the problems

To solve said problem, the invention has the following constitution:

(1) A film for solar battery backside sealing component comprising a resin layer containing a resin produced by copolymerizing an acrylic polyol resin, an ultraviolet absorber, and a photostabilizing agent, the film further comprising a color pigment and a plasticizer, wherein the resin layer is laminated to at least one side of a base film

(2) A film for solar battery backside sealing component as described in paragraph (1) wherein said plasticizer is at least one selected from the group of polyester plasticizer, epoxy plasticizer, and phthalic acid ester plasticizer

(3) A film for solar battery backside sealing component as described in either paragraph (1) or (2) wherein said resin layer contains polyisocyanate resin

(4) A film for solar battery backside sealing component as described in paragraph (3) wherein said polyisocyanate resin is at least one selected from the group of aliphatic isocyanate resin, alicyclic isocyanate resin, and araliphatic isocyanate resin

(5) A film for solar battery backside sealing component as described in any of paragraphs (1) to (4) wherein said color pigment is titanium oxide

(6) A solar battery backside sealing component comprising at least a film selected from the group of white film, film with a deposited inorganic oxide layer, and film that can be heat-bonded to a vinyl acetate copolymer, laminated to the opposite side to the resin layer side of a film for solar battery backside sealing component as described in any of paragraphs (1) to (5)

(7) A solar cell module wherein its silicon cell filler layer side is bonded to the opposite side to said resin layer side of a solar battery backside sealing component as described in paragraph (6)

Effect of the invention

According to the invention, it is possible to produce a film for solar battery backside sealing component comprising a pigmented layer that has high light resistance and moist heat resistance to serve for long term use in a harsh outdoor environment, as well as good decorative properties and high adhesion strength to silicone resin for bonding to terminal boxes that is required when used as outermost layer.

The film for solar battery backside sealing component of the invention serves to produce a solar battery backside sealing component that can develop a strong contact with a silicon cell filler layer, have a high light reflectance, improve the performance of a solar cell module, and maintain it for a long period of time.

Best mode for carrying out the invention

[Film for solar battery backside sealing component]

The film for solar battery backside sealing component of the invention comprises a resin layer containing a resin produced by copolymerizing an acrylic polyol resin, an ultraviolet absorber, and a photostabilizing agent, the film further comprising with a color pigment and a plasticizer, wherein the resin layer is laminated to at least one side of a base film, and serves to produce a pigmented layer that has high light resistance and electrical insulating properties compared with conventional materials, as well as good decorative properties and high adhesion strength to silicone resin for bonding to terminal boxes that is required when used as outermost layer.

[Base film]

Various resin films can be used as the base film of the film for solar battery backside sealing component of the invention. Specifically, they include polyester resin films such as polyethylene terephthalate (PET) and polyethylene naphthalate (PEN); other resin films such as polycarbonate, polymethyl methacrylate, polyacrylate, polypropylene, and polyethylene; and resin films of mixtures thereof. In particular, polyester resin films are preferable because of their strength, dimensional stability, and heat stability, and such polyethylene terephthalate films as PET and PEN are particularly preferable because they are low in price. These polyester resins may be copolymers, and the usable copolymer components include, for instance, diol components such as propylene glycol, diethylene glycol, neopentyl glycol, and cyclohexanedimethanol; and dicarboxylic acid components such as isophthalic acid, adipic acid, azelaic acid, sebacic acid, ester-forming derivatives thereof.

As the film for solar battery backside sealing component of the invention has a high light resistance, it can serve effectively as the outermost layer of a solar battery backside sealing component, which is directly exposed to outdoor air (humidity, temperature) and ultraviolet rays reflected from the ground surface. It is preferable that a highly hydrolysis resistant resin film is used the base film considering the case where it is used as outmost layer directly exposed to outdoor air. Common polyester resin films are formed of a so-called polymer produced through condensation polymerization of monomers that contains oligomers, intermediate materials between monomer and polymer, up to about 1.5 to 2 mass%. Such oligomers are mainly cyclic trimmers, and films containing them up to a large content can suffer deterioration in mechanical strength and cracking and fracture caused by hydrolysis with rain water as they are exposed to outdoor air etc. for a long period of time. To provide a hydrolysis resistant film, on the other hand, a polyester resin film is produced from a polyester resin with a cyclic trimer content of 1.0 mass% or less synthesized through solid phase polymerization. Thus, hydrolysis can be depressed under high temperature, high humidity conditions, and the resulting film will be also high in heat resistance and weather resistance. To determine the cyclic trimer content, a solution of, for instance, 100 mg of a polymer dissolved in 2 ml of orthochlorophenol is used for liquid chromatography to measure its weight (wt%) relative to the weight of the resin.

The film for solar battery backside sealing component may contain, for instance, additives such as antistatic agent, ultraviolet absorber, stabilizer, antioxidant, plasticizer, lubricant, filler, and color pigment, as needed, as long as they do not impair the effect of the invention.

Specifically, usable films include those produced from resins consisting of white pigments kneaded in such materials as polyester resins including polyethylene terephthalate (PET) and polyethylene naphthalate (PEN), and other resin including polycarbonate, polymethyl methacrylate, polyacrylate, polypropylene, and polyethylene. Such a white film is used with the aim of reflecting the light reaching the backside sheet in order to assist the energy conversion in the semiconductor element, and it is preferable that the film is provided in a layer near the cell. Such a white film used as base film reflects sunlight to increase the power generation efficiency. The white film preferably is a film having a reflectance of 30% or more, more preferably 40% or more, and still more preferably 50% or more, for light with a wavelength, $\lambda$, of 550 nm. In particular, polyester resin films are preferable because of their high strength, dimensional stability and heat stability, and polyethylene terephthalate films such as PET and PEN are particularly preferable because they are less expensive. The polyester resin that constitutes the polyester resin film may be polyethylene terephthalate with ethylene terephthalate accounting for 80 mol% or more of the constituent units, polyethylene naphthalate with ethylene naphthalate accounting for 80 mol% or more of the constituent units, or polylactic acid resin with polylactic acid accounting for 80 mol% or more of the constituent units, though there are no specific limitations. Furthermore, the polyester resin may be a copolymer, and the usable copolymer components include, for instance, diol components such as propylene glycol, diethylene glycol, neopentyl glycol, and cyclohexanedimethanol, and dicarboxylic acid components such as isophthalic acid, adipic acid, azelaic acid, sebacic acid, and ester-forming derivatives thereof.

The usable white pigments include titanium oxide and zinc oxide, and they may be kneaded into a white resin film with a whiteness of 80% or more and an opacity of 80% or more.

The white resin film may contain, for instance, additives such as antistatic agent, ultraviolet absorber, stabilizer, antioxidant, plasticizer, lubricant, and filler, as needed, as long as they do not impair the effect of the invention.

There are no specific limitations on the thickness of the resin film for solar battery backside sealing component, but it is preferably in the range of 25 to 250 $\mu$m in view of the dielectric strength, cost, and the like of the sealing component.

The base film may be a moisture barrier film comprising at least one inorganic oxide layer formed by deposition etc. with the aim of developing water vapor barrier properties. The "moisture barrier film" as referred to herein for the invention is a resin film with a moisture transmission coefficient of 5g/(m$^2$.day) or less as measured by the B method specified in JIS K7129 (2000). Such a moisture barrier film may be produced by forming at least one thin metal film layer or inorganic oxide layer by deposition etc. on at least one surface of polyester resin film, such as polyethylene terephthalate (PET) and polyethylene naphthalate (PEN), or olefin-based film, such as polypropylene. For use as solar battery backside sealing component, an inorganic oxide layer is preferable to a thin metal film layer with electric conductivity because the component is required to have good electrical insulating properties.

For use as the base film, polyester resin films are preferable because of their high strength, dimensional stability and heat stability, and polyethylene terephthalate films such as PET and PEN are particularly preferable because they are less expensive. The polyester resin that constitutes the polyester resin film may be polyethylene terephthalate with ethylene terephthalate accounting for 80 mol% or more of the constituent units, or polyethylene naphthalate with ethylene naphthalate accounting for 80 mol% or more of the constituent units, though there are no specific limitations. Furthermore, the polyester resin may be a copolymer, and the usable copolymer components include, for instance, diol components such as propylene glycol, diethylene glycol, neopentyl glycol, and cyclohexanedimethanol, and dicarboxylic acid components such as isophthalic acid, adipic acid, azelaic acid, sebacic acid, and ester-forming derivatives thereof. The gas barrier properties of the film with an inorganic oxide layer formed by deposition etc. are attributed at least to the dimensional stability at high temperatures of the polyester resin film used as base material, and therefore, it is preferable that the polyester resin film is a biaxially stretched film.

Practically, the resin film preferably has a thickness in the range of 1 to 100 $\mu$m, more preferably 5 to 50 $\mu$m, and particularly preferably about 10 to 30 $\mu$m, from the viewpont of stability in the inorganic oxide layer formation step as well as production costs.

The inorganic oxides that can serve to constitute the inorganic oxide layer formed for the invention include, for instance, metal oxides and metal nitride oxides. The inorganic oxide layer can be produced by deposition, sputtering, ion plating, or plasma vapor deposition (CVD). From the viewpoint of productivity, however, vacuum deposition is the best method at the present time. It is preferable that the vacuum deposition equipment used for the vacuum deposition adopts electron beam heating, resistance heating, or induction heating as heating means. The usable metal oxides to constitute the inorganic oxide layer include aluminum oxide, magnesium oxide, titanium oxide, oxidized tin, indium oxide alloy, and silicon oxide, while the usable metal nitride oxides include silicon oxynitride. In particular, inorganic oxides such as aluminum oxide, silicon oxide, silicon oxynitride, and mixtures thereof are used preferably from the viewpoint of moisture barrier properties and production efficiency.

Depending on the inorganic substance and constitution to be used, it is commonly preferable that the inorganic oxide layer has a film thickness in the range of 2 to 300 nm, more preferably 3 to 100 nm, and still more preferably 5 to 50 nm. If the film thickness is more than 300 nm, the layer, particularly in the case of a metal oxide layer, may suffer a decrease in flexibility, possibly leading to cracks, pinholes, etc., in the thin film caused by an external force of bending, stretching, etc., after the film production process (during post-processing steps etc.), which may cause serious deterioration in the moisture barrier properties. Furthermore, the growth rate of the inorganic layer will decrease, which may cause a large decrease in productivity. If the film thickness is less than 2 nm, on the other hand, it will be difficult to form a uniform film, or the film may not be thick enough, possibly failing to develop sufficient moisture barrier properties.

In addition, the resin film may be subjected to discharge treatment such as corona discharge and plasma electrical discharge, and surface treatment such as acid treatment, as required.

[Resin layer]

The resin layer to be formed on the surface of the base film for the present invention consists of: (1) a resin produced by copolymerizing an acrylic polyol resin, an ultraviolet absorber, and a photostabilizing agent, (2) a color pigment, and (3) a plasticizer. Commonly, a resin layer with ultraviolet screening capability and improved light resistance is produced by adding one or more organic ultraviolet absorbers and/or inorganic ultraviolet absorbers to the binder resin, along with a photostabilizing agent (HALS) with the aim of increasing the photostability through a mechanism for deactivating radicals that could be excited by light. A resin layer produced by adding, in a later step, ultraviolet absorbers and photostabilizing agents to a binder resin, however, can suffer bleed-out of the ultraviolet absorbers and photostabilizing agents from inside the coat film to the surface of the coat film when exposed to a high temperature, high humidify environment and ultraviolet rays, leading not only to changes in the wettability and contact strength of the coat surface, but also the problem of losing the initially existing ultraviolet screening capability.

The present invention, on the other hand, uses a binder resin that consists of an acrylic resin, which is relatively high in light resistance compared to polyester resins and olefin resins, copolymerized with an ultraviolet absorber and a photostabilizing agent. To improve the strength of contact with the base film and to form a highly heat resistant rsin layer, which is exposed to high processing temperatures during the solar cell module production step, on the surface of the solar battery backside sealing component of the film for solar battery backside sealing component of the invention, acrylic polyol resin is used, among other acrylic resins, because appropriate crosslinked structures can be introduced.

As the copolymerizable monomers to fix the ultraviolet absorber and photostabilizing agent, it is preferable to use vinyl monomers, such as acrylic- or styrene-type, as they serve for various purposes and they are low in price. Of these copolymerizable monomers, styrene-type vinyl monomers can be easily yellowed because of the aromatic ring contained, while acrylic-type vinyl monomers are most preferable in terms of light resistance. Thus, at least one of the polymerizable monomer components to constitute the acrylic resin should be one or more unsaturated compounds selected from the group of unsaturated carboxylate, unsaturated carboxylic acid, unsaturated hydrocarbon, and vinyl ester.

The usable unsaturated carboxylates include methyl methacrylate, methyl acrylate, ethyl acrylate, ethyl methacrylate, n-propyl acrylate, n-propyl methacrylate, isopropyl acrylate, isopropyl methacrylate, n-butyl acrylate, n-butyl methacrylate, isobutyl acrylate, isobutyl methacrylate, t-butyl acrylate, t-butyl methacrylate, 2-ethylhexyl acrylate, and 2-ethylhexyl methacrylate.

The usable unsaturated carboxylic acids include acrylic acid, methacrylic acid, maleic acid, itaconate, crotonic acid, and fumaric acid.

The usable other monomers include butadiene, ethylene, and vinyl acetate. Unsaturated carboxylates are preferable. Of the unsaturated carboxylates, methyl methacrylates and methyl acrylates are particularly preferable in terms of general versatility, price, and photostability.

Described below is the polymerizable monomer to be used to form an acrylic polyol resin by introducing hydroxyl groups which act as stating points of crosslinking and serve to form a highly heat resistant resin layer. The polymerizable monomer components that can be used to introduce a hydroxyl group into acrylic resin include, for example, unsaturated monomers such as 2-hydroxyethyl acrylate, 2-hydroxyethyl methacrylate, 2-hydroxypropyl acrylate, 2-hydroxypropyl methacrylate, 2-hydroxybutyl acrylate, 2-hydroxybutyl methacrylate, 2-hydroxyvinyl ether, polyethylene glycol methacrylate, polypropylene glycol monoacrylate, and polypropylene glycol monomethacrylate. These unsaturated compounds having a hydroxyl group may be used singly or as a mixture of two or more thereof.

The resin layer of the invention preferably has a thickness of 0.2 to 5 $\mu$m, more preferably 1 to 4 $\mu$m, and still more preferably 2 to 4 $\mu$m. In the case where this resin layer is formed by coating, phenomena such as cissing and film breakage can take place during the coating process if a resin layer with a thickness less than 0.2 $\mu$m is to be formed. It will be difficult to produce a uniform coat film, possibly failing to develop a sufficient strength of contact with the base film and in particular failing to achieve a sufficient ultraviolet screening capability. If a resin layer with a thickness of more than 5 $\mu$m is to be produced, on the other hand, a sufficient ultraviolet screening capability will be developed, but there will be limitations on the coating method to be used (special process or equipment to perform thick coating), and high production costs will be required. In addition, other disadvantages such as adhesion of the coat film to the rolls used for transportation may occur, possibly leading to peeling of the coat film.

If the resin layer of the invention is to be formed by coating, the solvents that can serve to prepare a coating liquid include, for instance, toluene, xylene, ethyl acetate, butyl acetate, acetone, methyl ethyl ketone, methyl isobutyl ketone, tetrahydrofuran, dimethyl formamide, dimethyl acetamide, methanol, ethanol, and water, and the coating liquid to be used may be either in the form an emulsion or a solution.

There are no specific limitations on the method to be used to form a resin layer on the base film, and a generally known coating method may be used. The various usable methods include, for instance, roll coating, dip coating, bar coating, die coating, gravure roll coating, and combinations thereof. Of these, gravure roll coating is preferable because the composition for coat layer formation can be highly stabilized.

[Ultraviolet absorber]

The usable ultraviolet absorbers to be copolymerized with said acrylic polyol resin include those ultraviolet absorbers based on salicylic acid, benzophenone, benzotriazole, or cyanoacrylate. Specifically, they include, for instance, salicylic acid based ones such as p-t-butyl phenyl salicylate and p-octyl phenyl salicylate, benzophenone based ones such as 2,4-dihydroxybenzophenone, 2-hydroxy-4-methoxy benzophenone, 2-hydroxy-4-methoxy-5-sulfobenzophenone, 2,2',4,4'-tetrahydroxy benzophenone, bis(2-methoxy-4-hydroxy-5-benzoyl phenyl) methane, benzotriazole based ones such as 2-(2'-hydroxy-5'-methyl phenyl) benzotriazole, 2-(2'-hydroxy-5'-methyl phenyl) benzotriazole, 2,2'-methylene bis[4-(1,1,3,3-tetramethylbutyl) -6-(2Hbenzotriazole-2-yl) phenol], cyanoacrylate based ones such as ethyl-2-cyano-3,3'-diphenyl acrylate), and others such as 2-(4,6-diphenyl-1,3,5-triazine-2-yl) -5-[(hexyl) oxy]-phenol, along with modified or polymerized products and derivatives thereof.

[Photostabilizing agent]

Similarly, the usable photostabilizing agents to be copolymerized with said acrylic polyol resin include, for instance, those based on hindered amine. Specifically, they include bis(1,2,2,6,6-pentamethyl-4-piperidyl) [[3,5-bis(1,1-dimethylethyl)-4-hydroxyphenyl]methyl] butyl malonate, bis(1,2,2,6,6-pentamethyl-4-piperidyl) sebacate, methyl (1,2,2,6,6-pentamethyl-4-piperidyl) sebacate, decanedioic acid bis[2,2,6,6-tetramethyl-1-octyl oxy]-4-piperidinyl] ester, and modified or polymerized products and derivatives thereof.

A production method etc. to copolymerize an acrylic polyol resin with an ultraviolet absorber and a photostabilizing agent is described in detail in paragraphs [0019] to [0039] of Japanese Unexamined Patent Publication (Kokai) No. 2002-90515. In particular, it is preferable to use HALS Hybrid (registered trademark) (supplied by Nippon Shokubai Co., Ltd.), which contains a copolymer of an acrylic monomer and an ultraviolet absorber as active elements.

[Color pigments]

For the invention, color pigments are used with the aim of developing colors in resin layers and maintaining their tones (preventing their deterioration). Among the various solar battery backside sealing sheets, white ones are dominant from the viewpoint of light reflectivity and decorative appearance, but recently, demands for black sheets have expanded on the ground that they appear better than white ones that form apparently white gaps between the electric generating elements. Moreover, as these pigments themselves absorb and/or reflect rays of specific wavelengths, coloring can serve to protect resin materials from light.

The usable color pigments include inorganic, organic, and other various pigments, but of the color pigments currently in practical use, titanium oxide and carbon black are preferable as white and black pigments, respectively, from the viewpoint of general-purpose properties, price, color development performance, and ultraviolet resistance. In particular, titanium oxide pigments preferably have a number average particle diameter of 0.1-1.0 $\mu$m from the viewpoint of color development, more preferably 0.2-0.5 $\mu$m from the viewpoint of dispersibility in acrylic polyol resins as well as cost. Similarly, carbon black pigments preferably have a number average particle diameter of 0.01-0.5 $\mu$m, more preferably 0.02-0.1 $\mu$m from the viewpoint of dispersibility and cost.

The blending quantities of these color pigments may be adjusted appropriately to meet intended color designs. Here, good decorative color appearance cannot be developed if the content of pigments is too low, while large costs will be required and a largely increased hardness of the resin layer will cause deterioration in its contact with the base material if the content is too high. Thus, it is preferable that the content is in the range of 10-500 parts by mass relative to 100 parts by mass of said resin produced by copolymerizing an acrylic polyol resin, an ultraviolet absorber, and a photostabilizing agent.

[Plasticizer]

Described below are plasticizers to be added to the resin layer of the invention. For the invention, plasticizers contribute to improving the contact strength between the base film and the resin layer containing an acrylic polyol resin and a color pigment. Generally, acrylic polyol resins are not particularly low in the contact strength with various resin films. But if a color pigment is added up to a relatively high content with the aim of coloring the resin layer, the resin layer increases in hardness, and furthermore, the contact strength between the base film and the resin layer will tend to decrease as the content of the acrylic polyol resin in the resin layer decreases relatively. The hardness of the resin layer can be adjusted and the contact strength with the base film can be improved by adding a plasticizer component that has a lower softening point than the acrylic polyol resin. Plasticizers such as polyester plasticizer, epoxy plasticizer, phthalic acid ester plasticizer, and combinations thereof are preferable for the invention from the viewpoint of heat resistance, weather resistance, cost, and general purpose properties.

The preferable polyester plasticizers include, for instance, adipic acid plasticizer. The preferable epoxy plasticizers include, for instance, epoxidized fatty acid ester. The preferable epoxy plasticizers also include epoxidized vegetable oil such as, for instance, epoxidized soybean oil and epoxidized linseed oil. The preferable phthalic acid ester plasticizers include, for instance, dioctyl phthalate, diisononyl phthalate, diisodecyl phthalate, and dibutyl phthalate.

The plasticizers to be used for the invention include, for instance, Polysizer W-220 EL (polyester plasticizer supplied by DIC Corporation), Eposizer W-121 (epoxy plasticizer supplied by DIC Corporation), Eposizer W-100-EL (epoxidized soybean oil plasticizer supplied by DIC Corporation), and dioctyl phthalate (phthalic acid ester plasticizer supplied by DIC Corporation).

The content of these plasticizers is preferably in the range of 4-40 parts by mass, more preferably 10-30 parts by mass, relative to 100 parts by mass of said resin produced by copolymerizing an acrylic polyol resin, an ultraviolet absorber, and a photostabilizing agent. If the content of the plasticizers is less than 4 parts by mass, they can have little effect and may not be expected to improve the contact strength sufficiently. If it is more than 40 parts by mass, on the other hand, the relative content of the acrylic polyol resin containing an ultraviolet absorber and a photostabilizing agent in the resin layer will largely decrease, leading to a decrease in the ultraviolet resistance of the resin layer itself and possibly causing deterioration in the function to protect the base film from ultraviolet rays (ultraviolet screening capability).

[Other additives]

In addition, the coating liquid containing an acrylic polyol resin for the invention may contain a thermal stabilizer, antioxidant, toughening agent, antidegradant, weathering agent, flame retardant, mold releasing agent, and lubricant, as long as they do not impair its characteristics.

The usable thermal stabilizers, antioxidant and antidegradants include, for instance, hindered phenols, phosphorus compounds, hindered amines, sulfur compounds, copper compounds, halogenated alkali metals, and mixtures thereof.

The usable toughening agents include, for instance, clay, talc, calcium carbonate, zinc carbonate, wollastonite, silica, alumina, magnesium oxide, calcium silicate, sodium aluminate, sodium aluminosilicate, magnesium silicate, glass balloon, carbon black, zinc oxide, zeolite, hydrotalcite, metal fiber, metal whisker, ceramic whisker, potassium titanate whisker, boron nitride, graphite, glass fiber, and carbon fiber.

[Crosslinking agent]

As described above, a crosslinking agent with a functional group that can react with the hydroxyl group in the acrylic polyol may be added with the aim of improving the characteristics of the resin layer. If a crosslinking agent is used in combination, it will serve to improve the contact strength between the base film and the resin layer, and also improve the heat resistance of the resin layer as a result of the introduction of crosslinked structures. In particular, when a solar battery backside sealing component is designed to use the resin layer of the invention as the outermost layer, the resin layer should have a particularly high heat resistance because it will be exposed to high temperatures up to a maximum of about 150°C for a long period of time of up to 30 minutes or longer during the solar cell module production process, specifically during the glass lamination step (cell filling step). The present invention uses a resin produced by copolymerizing an acrylic polyol resin, an ultraviolet absorber and a photostabilizing agent, and therefore, it is possible to use a crosslinking agent that can react with the hydroxyl group contained in the resin. In particular, it is preferable to use polyisocyanate resin as curing agent to accelerate the formation of urethane bonds (crosslinked structure). The polyisocyanates that serve as crosslinking agent include aromatic polyisocyanates, araliphatic polyisocyanates, alicyclic polyisocyanates, and aliphatic polyisocyanates, and the resin to be used may be produced from the diisocyanate compounds listed below.

Aromatic polyisocyanates may be produced from such diisocyanates as m- or p-phenylene diisocyanate, 4,4'-diphenyl diisocyanate, 1,5-naphthalene diisocyanate (NDI), 4,4'-, 2,4'- or 2,2'-diphenyl methane diisocyanate (MDI), 2,4- or 2,6-tolylene diisocyanate (TDI), and 4,4'-diphenyl ether diisocyanate.

Araliphatic polyisocyanates may be produced from such diisocyanate as 1,3- or 1,4-xylylene diisocyanate (XDI) and 1,3- or 1,4-tetramethyl xylylene diisocyanate (TMXDI).

Alicyclic polyisocyanate may be produced from such diisocyanates as 1,4-cyclohexane diisocyanate, 1,3-cyclohexane diisocyanate, 3-isocyanate methyl-3,5,5-trimethyl cyclohexyl isocyanate (isophorone diisocyanate ; IPDI), 4,4'-, 2,4'- or 2,2'-dicyclohexyl methane diisocyanate (hydrogenated MDI), methyl-2,4-cyclohexane diisocyanate, methyl-2,6-cyclohexane diisocyanate, and 1,3- or 1,4-bis(isocyanate methyl)cyclohexane (hydrogenated XDI).

Aliphatic polyisocyanates may be produced from such diisocyanates as trimethylene diisocyanate, tetramethylene diisocyanate, hexamethylene diisocyanate (HDI), pentamethylene diisocyanate, 1,2-propylene diisocyanate, 1,2-, 2,3- or 1,3-butylene diisocyanate, and 2,4,4- or 2,2,4-trimethyl hexamethylene diisocyanate.

A polyisocyanate can be produced from a mixture of two or more of these diisocyanates, or from biuret-modified (aliphatic) or nurate-modified (alicyclic) forms thereof. For the production of the polyisocyanate, in particular, it is preferable to use a curing agent composed mainly of an alicyclic isocyanate or an aliphatic isocyanate because resins with a skeleton containing an aromatic ring that has a light absorption band in the ultraviolet region are easily yellowed when irradiated with ultraviolet rays. Furthermore, ethanol is used frequently in the solar battery module finishing step to wipe off resin and dirt from the outermost surface of the solar battery backside sealing component, and therefore, the outermost surface of the solar battery backside sealing component is required to be resistant to ethanol. The use of a curing agent composed mainly of an alicyclic isocyanate can cure the resin layer faster and make it more resistant to ethanol than a curing agent composed mainly of an aliphatic isocyanate, and therefore, it is preferable to use an alicyclic polyisocyanate. In particular, the use of a nurate-modified hexamethylene diisocyanate is preferable from the viewpoint of its high crosslinking reaction with acrylic polyol resins, degree of crosslinking, heat resistance, ultraviolet resistance, and the like.

[Solar battery backside sealing component]

A solar battery backside sealing component can be produced by laminating a film for solar battery backside sealing component produced according to the invention to another resin film, and the generally known dry lamination method can be used to combining the films into a sheet. For combining the resin films by dry lamination, it is possible to use a generally known adhesive for dry lamination that consists of a base resin such as polyether poly polyurethane, polyester polyurethane, polyester, and polyepoxy resin, and a curing agent of polyisocyanate resin. The adhesive layer of these adhesives, however, should not suffer delamination as a result of deterioration in the adhesive strength attributed to long term outdoor use, or undergo yellowing that could lead to a decrease in the light reflectance. The adhesive layer preferably has a thickness in the range of 1 to 5 $\mu$m. An adequate adhesive strength may not be achieved if it is less than 1 µm. If it is more than 5 µm, on the other hand, it is not preferable because the adhesive application speed cannot be increased, and a long aging time will be necessary to develop a required adhesive strength (to accelerate the crosslinking reaction between the base resin and the curing agent). Furthermore, a large amount of the adhesive will be required, and all these will lead to increased production costs.

A generally known adhesive for dry lamination can be used as material to form an adhesive layer necessary for the invention. A common adhesive for dry lamination consists of two resins, i.e. base resin and crosslinking agent, diluted and adjusted with a diluent solvent. The crosslinking agent to be used is preferably a polymer containing an isocyanate group, which may be high in reactivity with active hydroxyl groups and also high in reaction rate and can develop an initial contact strength quickly. In addition to these advantages, it serves to produce an adhesive resin layer that is high in the adhesive strength to the base film, and the adhesive strength is maintained stably at high temperatures durably for a long period of time. The base resin to be used with this polymer containing an isocyanate group may be, for instance, a polyether-, polyester-, or polyol-based urethane resin or an epoxy resin, and an appropriate one may be selected to meet the detailed required characteristics and processing conditions. Depending on the constitution of the solar battery backside sealing component, it is likely that ultraviolet rays can reach the adhesive layer to cause degradation of the resin. From this viewpoint, the resin to be used to form the adhesive layer is preferably an aliphatic resin or an alicyclic resin in which aromatic rings do not exist or account for a very small part.

Described below is the solar battery backside sealing component produced from the film for solar battery backside sealing component of the invention. The solar battery backside sealing component is required to have various characteristics including, for instance, moisture barrier properties, light reflectivity, long term moist heat resistance and light resistance, high contact strength with cell fillers, and electrical insulating properties. To meet these required characteristics, efforts are being made in the industrial sector to provide various sheet designs (laminate designs) that combine different functional films with processing techniques such as deposition and wet coating, based on the concept of functional partition.

According to the invention, protect sheets for solar battery backside sealing that meet various required characteristics can be produced by combining the film for solar battery backside sealing component of the invention with one or more films selected from the following group: a hydrolysis resistant film, a white film, a film with a deposited inorganic oxide layer, or a film that can be heat-bonded to EVA. It is preferable that these films are different from the base film used in the film for solar battery backside sealing component. In particular, that portion of the solar battery backside sealing component which is exposed when built in a solar cell module should preferably be formed of a hydrolysis resistant, light resistant film that consists of a hydrolysis resistant film as described above, which serves as base film, and the resin layer of the invention formed on the base film. The use of a hydrolysis resistant film serves to prevent the inner layers (adhesive layer, film layer, etc.) from being hydrolyzed. In addition, a film with an ultraviolet screening capability is used to form the outermost layer to protect the inner layers from ultraviolet rays. It is preferable, on the other hand, that one or more of the group of a white film, a film with a deposited inorganic oxide layer, and a film that can be heat-bonded to EVA is laminated to the opposite side of the base film to the resin layer side. The white film works to form a light reflective layer, and the film with a deposited inorganic oxide layer acts to develop moisture barrier properties. The film that can be heat-bonded to EVA serves to enhance the strength of contact with cell filler layers. Furthermore, not only one but two or more films that meet various required characteristics may be laminated to the film for solar battery backside sealing component of the invention to provide solar battery backside sealing components of intended designs.

In its constitution, the solar battery backside sealing component may contain a deposited layer, sputtered layer, wet coating layer, and the like to develop specific functions, at any position including on the resin layer of the invention.

[Solar battery module]

In applying the solar battery backside sealing component prepared as described above to a solar battery module, the opposite side of the solar battery backside sealing component to the resin layer side is brought into contact with the silicon cell filler layer surface of the solar battery module, i.e. incorporated in the solar battery module with the resin layer side of the solar battery backside sealing component facing outside.

Examples

The film for solar battery backside sealing component of the present invention and the solar battery backside sealing component produced thereof will now be illustrated in greater detail with reference to Examples. The term "part (s)" as referred to herein means "part(s) by mass" unless specified otherwise.

< Methods for characteristics evaluation >

The methods used for characteristics evaluation for the invention are as described below.

(1) Measurement of coating weight

To determine the coating weight for the light resistant coat layer (resin layer), a resin layer was coated and a test piece with an area of 500 cm$^2$ was cut out, followed by measuring its mass, which is referred as mass (1). From the test piece, the resin layer was dissolved and removed in methyl ethyl ketone, and the mass of the test piece was measured, which is referred as mass (2). Subsequently, the coating weight per unit area was calculated by the following formula. Measurements were made for three test pieces, and their average was taken for evaluation.

$$\text{Coating weight } [g/m^2] = \{(\text{mass (1))} - (\text{mass (2))}\} \times 20$$

(2) Measurement of water vapor transmittance

Measurements were made using water vapor transmittance measure equipment (Model: Permatran (registered trademark) W3/31 supplied by Mocon, Inc., U.S.A.) under the conditions of a temperature 40°C and a humidity 90% RH according to the B method (infrared sensing) specified in JIS K7129 (2000). A measurement of water vapor transmittance was made for each of two test pieces, and their average was taken for evaluation. A test piece is acceptable if its water vapor transmittance is 5 g/(m$^2$. day) or less.

(3) Evaluation for ultraviolet screening capability (spectroscopic measurement)

To evaluate the ultraviolet screening capability of the film for solar battery backside sealing component, spectroscopic analysis was carried out with a UV-Vis-NIR spectrophotometer (UV-3150 supplied by Shimadzu Corporation) according to JIS K 7105 (2006). The light screening capability in the ultraviolet region was evaluated based on transmittance measurements at a wavelength of 360 nm. A test piece is acceptable if its light transmittance at wavelength 360 nm is 5% or less.

(4) Evaluation for strength of contact between base film and coat layer (resin layer)

To evaluate the strength of contact (coat layer contact strength) between the base film and the coat layer in a film for solar battery backside sealing component prepared, test pieces were subjected to crosscut test according to the method described in JIS K 5400 (1990), and evaluated according to the following criterion.
++: 100 out of 100 squares remaining
+: 81 to 99 out of 100 squares remaining
-: 80 or less out of 100 squares remaining

(5) Evaluation for ultraviolet resistance

Test pieces were irradiated with ultraviolet rays with a strength of 160 mW/cm$^2$ for 120 or 240 hours in an environment of 60°C and 50%RH, and the b-value in the color system was measured with a ultraviolet tester (Eye Super UV Tester SUV-W151 supplied by Iwasaki Electric Co., Ltd.). For test pieces of the film for solar battery backside sealing, the ultraviolet screening capability and the contact strength between the base film and the coat resin were measured to evaluate the effect of ultraviolet irradiation on these characteristics. Here, the ultraviolet resistance of the outer surface of the solar battery backside sealing component samples prepared Examples and Comparative examples was evaluated in terms of the changes in the b-value according to the color system caused by ultraviolet ray irradiation for 240 hours under said irradiation conditions.

(6) Evaluation for moist heat resistance

Test pieces of the film for solar battery backside sealing component were heat-treated for 48 or 96 hours in an environment of 120°C and 100% RH in a pressure cooker (TPS-211 supplied by Espec Corp.). Subsequently, the test pieces of the film for solar battery backside sealing component were subjected to measurement of the ultraviolet screening capability and the contact strength between the base film and the coat resin to evaluate the effect of moist heat treatment on these characteristics.

(7) Evaluation for ethanol resistance

To evaluate the ethanol resistance of a light resistant coat layer, a test piece was immersed in ethanol for 5 minutes, and subsequently rubbed 50 times with Kimwipe (registered trademark), followed by observing the appearance of the coat film and evaluating it as follows.
+: no change found in treated coat film
-: peeling found between base material and coat film

(8) Measurement of adhesive strength to filler

The adhesive strength to EVA sheets was measured according to JIS K 6854. The pseudo solar cell module samples used for the test were prepared by laminating an EVA sheet to the inner side surface of a backside sealing component produced (opposite side of the base film to the coated side), further laminating a 0.3 mm thick semi-reinforced glass on top of it, vacuuming it using a commercially available glass laminator, and pressing it for 15 minutes under a load of 29.4 N /cm$^2$ at an elevated temperature of 135°C. EVA sheets with a thickness of 500 $\mu$m supplied by Sanvic Inc. were used. Test pieces with a width of 10 mm were used for the adhesive strength test. A measurement of adhesive strength was made for each of two test pieces, and their average was taken for evaluation. An adhesive strength of 100 N/50 mm or more was assumed to be practically acceptable.

(9) Evaluation for adhesiveness of silicone resin for bonding to junction box

The adhesive strength between the light resistant coat layer and special silicone resin used to bonding it to a terminal box (junction box) in an electric system was evaluated by the method described below. The light resistant coat layer (resin layer) of a sample of the film for solar battery backside sealing component was coated with Solar PV (registered trademark) 804 supplied by Dow Coming Corporation, and another sample of the film for solar battery backside sealing component was put on it, with their light resistant coat layers facing to each other, and bonded. This bonded sample was left to stand at room temperature for one week for drying, and used for test. From this sample, three test pieces in the form of a strip with a width of 15 mm were cut out, and the adhesive strength at a peel angle of 90° was measured by the same procedure as used above for measuring the strength of adhesion to fillers. A measurement was made for each of the three strip test pieces, and their average was taken to represent the adhesive strength of the silicone resin. Lumiror (registered trademark) X10S supplied by Toray Industries, Inc., has been used practically as outermost layer film of solar battery backside sealing components, with a practically sufficient adhesive strength (8N/ 15mm) in bonding to silicone resin. Thus, this adhesive strength was used as criterion for practical required characteristics.

(Preparation of paints 1-5 for formation of light resistant coat layer (resin layer))

HALS Hybrid Polymer (registered trademark) BK1 (supplied by Nippon Shokubai Co., Ltd., solids content of 40 mass%, hereinafter referred to as acrylic resin 1), which is a coating material consisting of an acrylic polyol resin crosslinked with an ultraviolet absorber and a photostabilizing agent (HALS), was mixed with color pigments and solvents as specified in Table 1, and processed in a bead mill to ensure dispersion. Similarly, plasticizers were added then as specified in Table 1 to prepare base paints 1-5 for resin layer formation with a solids content of 50 mass%.
Then, a nurate type (alicyclic) hexamethylene diisocyanate resin (Desmodur (registered trademark) N3300 supplied by Sumika Bayer Urethane Co., Ltd., solids content 100 mass%) was added to the paint for resin layer formation prepared by the above method so that the solids content ratio to acrylic resin 1 of 33/8 as calculated in advance, and a calculated quantity of a diluent (n-propyl acetate) was weight out so that the resulting paint would have a solids content of 20 mass% (solid resin content), followed by stirring for 15 minutes. Thus, paints 1-5 for light resistant coat layer formation with a solids content of 20 mass% (solid resin content) were prepared.
For the above sample preparation, the color pigments and plasticizers listed below were used.
White pigments: titanium oxide particles, JR-709 supplied by Tayca Corporation
Black pigments: carbon black particles, Special Black 4A supplied by Degussa AG
Plasticizer 1: polyester plasticizer, Polysizer W-220EL supplied by DIC Corporation
Plasticizer 2: epoxy plasticizer, Eposizer W-121 supplied by DIC Corporation
Plasticizer 3: epoxidized soybean oil plasticizer, Eposizer W-100-EL supplied by DIC Corporation
Plasticizer 4: phthalic acid ester plasticizer, dioctyl phthalate supplied by DIC Corporation

(Preparation of paint 6 for formation of light resistant coat layer)

Except that a biuret-type (aliphatic) hexamethylene diisocyanate resin, Desmodur (registered trademark) N3200 (solids content 100 mass%) supplied by Sumika Bayer Urethane Co., Ltd., was used as curing agent instead of the nurate-type (alicyclic) hexamethylene diisocyanate resin, Desmodur (registered trademark) N3300 (solids content 100 mass%) supplied by Sumika Bayer Urethane Co., Ltd., the same procedure as for the preparation of paint 1 for light resistant coat layer formation was carried out to produce paint 6 for light resistant coat layer formation.

(Preparation of paint 7 for formation of light resistant coat layer)

Except that a resin (solids content 40 mass%, herein after referred to as acrylic resin 2) prepared by adding an ultraviolet absorber and a photostabilizing agent (HALS) in a later step without crosslinking to an acrylic resin produced from methyl methacrylic acid and 2-hydroxyethyl methacrylate was used instead of the HALS Hybrid Polymer (registered trademark) BKI(solids content 40 mass%), the same procedure as for the preparation of paint 1 for light resistant coat layer formation was carried out to produce paint 7 for light resistant coat layer formation.

(Preparation of paint 8 for formation of light resistant coat layer)

Except that no color pigment was used, the same procedure as for the preparation of paint 1 for light resistant coat layer formation was carried out to produce paint 8 for light resistant coat layer formation.

(Preparation of paint 9 for formation of light resistant coat layer)

Except that no plasticizer was used, the same procedure as for the preparation of paint 1 for light resistant coat layer formation was carried out to produce paint 9 for light resistant coat layer formation.

(Preparation of adhesive for dry lamination)

A mixture of 16 parts of a dry lamination material (Dicdry (registered trademark) LX-903 supplied by DIC Corporation), 2 parts by mass of a curing agent (KL-75 supplied by Dainippon Ink and Chemicals, Inc.), and 29.5 parts by mass of ethyl acetate was weighed out and stirred for 15 minutes to provide an adhesive for dry lamination with a solid content of 20 mass%.

(Preparation of paint for adhesive layer formation)

A mixture of 12 parts by mass of a dry lamination material (polyester polyurethane resin, Takelac (registered trademark) A-310 supplied by Mitsui Chemicals Polyurethanes, Inc.), 1 part by mass of an aromatic polyisocyanate resin (Takenate (registered trademark) A-3 supplied by Mitsui Chemicals Polyurethanes, Inc.), and 212 parts by mass of ethyl acetate was weighed out and stirred for 15 minutes to provide a paint for adhesive layer formation with a solid content of 3 mass%.

(Preparation of paint for heat-bonding resin layer formation)

A mixture of 20 parts by mass of an aqueous emulsion paint containing EVA type ternary copolymer resin (Aquatex (registered trademark) MC-3800 supplied by CSC Co., Ltd.), 10.8 parts by mass of isopropyl alcohol, and 22.6 parts by mass of water was weighed out and stirred for 15 minutes to provide a paint for heat-bonding resin layer formation with a solid content of 15 mass%.

[Table 1]

| | | | paint 1 | paint 2 | paint 3 | paint 4 | paint 5 | paint 6 | paint 7 | paint 8 | paint 9 |
|---|---|---|---|---|---|---|---|---|---|---|---|
| base resin composition | acrylic resin 1 *1 | parts by mass | 33.0 | 33.0 | 33.0 | 33.0 | 55.0 | 33.0 | | 83.0 | 35.0 |
| | acrylic resin 2 *2 | parts by mass | | | | | | | 33.0 | | |
| | titanium oxide | parts by mass | 60.0 | 60.0 | 60.0 | 60.0 | | 60.0 | 60.0 | | 65.0 |
| | carbon black | parts by mass | | | | | 33.0 | | | | |
| | plasticizer 1 | parts by mass | 7.0 | | | | 12.0 | 7.0 | 7.0 | 17.0 | |
| | plasticizer 2 | parts by mass | | 7.0 | | | | | | | |
| | plasticizer 3 | parts by mass | | | 7.0 | | | | | | |
| | plasticizer 4 | parts by mass | | | | 7.0 | | | | | |
| | ethyl acetate | parts by mass | 100.0 | 100.0 | 100.0 | 100.0 | 100.0 | 100.0 | 100.0 | 100.0 | 100.0 |
| | solids content in base resin | wt% | 50.0 | 50.0 | 50.0 | 50.0 | 50.0 | 50.0 | 50.0 | 50.0 | 50.0 |
| curing agent | isocyanate *3 | parts by mass | 8.0 | 8.0 | 8.0 | 8.0 | 13.0 | | 8.0 | 20.0 | 8.0 |
| | isocyanate *4 | parts by mass | | | | | | 8.0 | | | |
| diluted agent | acetic acid n-propyl | parts by mass | 332.0 | 332.0 | 332.0 | 332.0 | 352.0 | 332.0 | 332.0 | 380.0 | 332.0 |

(continued)

| | | | paint 1 | paint 2 | paint 3 | paint 4 | paint 5 | paint 6 | paint 7 | paint 8 | paint 9 |
|---|---|---|---|---|---|---|---|---|---|---|---|
| solids content in prepared paint | | mass% | 20.0 | 20.0 | 20.0 | 20.0 | 20.0 | 20.0 | 20.0 | 20.0 | 20.0 |

*1: acrylic polyol resin crosslinked with ultraviolet absorber and photostabilizing agent, HALS Hybrid Polymer (registered trademark) BK1 supplied by Nippon Shokubai Co., Ltd.
*2: acrylic polyol resin containing but not crosslinked with ultraviolet absorber and photostabilizing agent
*3: nurate-type hexamethylene diisocyanate resin, Desmodur (registered trademark) N3300 supplied by Sumika Bayer Urethane Co., Ltd.
*4: biuret-type hexamethylene diisocyanate resin, Desmodur (registered trademark) N3200 supplied by Sumika Bayer Urethane Co., Ltd.

(Example 1)

The base film used was a hydrolysis resistant polyethylene terephthalate film with a cyclic trimer content of 1 wt% or less (Lumiror (registered trademark) X10S (125 $\mu$m) supplied by Toray Industries, Inc.). Paint 1 for light resistant coat layer formation was spread with a wire bar over one side of this base film and dried at 150°C for 30 seconds to form a light resistant coat layer (resin layer) having a coating weight of 2.0 g/m$^2$ after drying. Thus, film 1 for solar battery backside sealing component (herein after referred as sealing component film) was produced.

(Example 2)

Except that a light resistant coat layer (resin layer) that would have a coating weight of 3.2 g/m$^2$ after drying, was formed, the same procedure as in Example 1 was carried out to produce sealing film 2.

(Example 3)

Except for spreading paint 2 for light resistant coat layer formation instead of paint 1 for light resistant coat layer formation, the same procedure as in Example 2 was carried out to produce sealing film 3.

(Example 4)

Except for spreading paint 3 for light resistant coat layer formation instead of paint 1 for light resistant coat layer formation, the same procedure as in Example 2 was carried out to produce sealing film 4.

(Example 5)

Except for spreading paint 4 for light resistant coat layer formation instead of paint 1 for light resistant coat layer formation, the same procedure as in Example 2 was carried out to produce sealing film 5.

(Example 6)

Except for spreading paint 5 for light resistant coat layer formation instead of paint 1 for light resistant coat layer formation, the same procedure as in Example 2 was carried out to produce sealing film 6.

(Example 7)

Except for spreading paint 6 for light resistant coat layer formation instead of paint 1 for light resistant coat layer formation, the same procedure as in Example 2 was carried out to produce sealing film 7.

(Comparative example 1)

Except for spreading paint 7 for light resistant coat layer formation instead of paint 1 for light resistant coat layer formation, the same procedure as in Example 2 was carried out to produce sealing film 8.

(Comparative example 2)

Except for spreading paint 8 for light resistant coat layer formation instead of paint 1 for light resistant coat layer formation, the same procedure as in Example 2 was carried out to produce sealing film 9.

(Comparative example 3)

Except for spreading paint 9 for light resistant coat layer formation instead of paint 1 for light resistant coat layer formation, the same procedure as in Example 2 was carried out to produce sealing film 10.

(Comparative example 4)

Lumiror (registered trademark) X10S (supplied by Toray Industries, Inc., 125 $\mu$m) was used as film 11 for solar battery backside sealing component without forming a light resistant coat layer, to provide a sample for the comparative example.

Characteristics of the light resistant films produced above in Examples 1 to 7 and Comparative examples 1 to 4 were evaluated by the evaluation methods described above. Results are shown in Tables 2 and 3.

[Table 2]

| No. | film | coat layer | | base material/coat film contact strength | | | ultraviolet screening performance (light transmittance at wavelength of 360 nm [%]) | | | ethanol resistance |
| --- | --- | --- | --- | --- | --- | --- | --- | --- | --- | --- |
| | | coating liquid | coating weight [g/m$^2$] | initial | after moist heat test | after UV irradiation | initial | after moist heat test | after UV irradiation | initial |
| Example 1 | sealing film 1 | paint 1 | 2.0 | ++ | ++ | ++ | less than 1 | less than 1 | less than 1 | + |
| Example 2 | sealing film 2 | paint 1 | 3.2 | ++ | ++ | ++ | less than 1 | less than 1 | less than 1 | + |
| Example 3 | sealing film 3 | paint 2 | 3.2 | ++ | + | ++ | less than 1 | less than 1 | less than 1 | + |
| Example 4 | sealing film 4 | paint 3 | 3.2 | ++ | + | ++ | less than 1 | less than 1 | less than 1 | + |
| Example 5 | sealing film 5 | paint 4 | 3.2 | ++ | ++ | ++ | less than 1 | less than 1 | less than 1 | + |
| Example 6 | sealing film 6 | paint 5 | 3.2 | ++ | ++ | ++ | less than 1 | less than 1 | less than 1 | + |
| Example 7 | sealing film 7 | paint 6 | 3.2 | ++ | ++ | ++ | less than 1 | less than 1 | less than 1 | - |
| Comparative example 1 | sealing film 8 | paint 7 | 3.2 | ++ | + | + | 1 or less | 3 | 2.5 | + |
| Comparative example 2 | sealing film 9 | paint 8 | 3.2 | ++ | ++ | ++ | less than 1 | less than 1 | less than 1 | + |
| Comparative example 3 | sealing film 10 | paint 9 | 3.2 | + | - | - | less than 1 | less than 1 | less than 1 | + |
| Comparative example 4 | sealing film 11 | N/A | N/A | N/A | N/A | N/A | 57 | 60 | 43 | + |

EP 2 369 637 B1

[Table 3]

| Example No. | Color change caused by UV irradiation b-value/L-value | | | |
|---|---|---|---|---|
| | (1) initial | (2) after UV irradiation | (3) after UV irradiation | Δ((3)-(1)) |
| | 0 hour | 120 hours | 240 hours | 0-240 hours |
| Example 1 | -2.02/71.8 | -1.85/72.1 | -1.56/72.8 | 0.46/1.0 |
| Example 2 | -2.08/73.1 | -1.81/73.7 | -1.55/74.5 | 0.53/1.4 |
| Example 3 | -2.01/72.9 | -1.85/73.3 | -1.45/74.9 | 0.56/2.0 |
| Example 4 | -2.08/73.7 | -1.82/74.5 | -1.52/74.8 | 0.56/1.1 |
| Example 5 | -1.99/73.9 | -1.75/74.2 | -1.4/75.1 | 0.59/1.2 |
| Example 6 | -0.64/13.4 | -1.18/16.3 | -1.32/17.3 | -0.68/3.9 |
| Example 7 | -2.09/73.2 | -1.82/73.6 | -1.56/74.6 | 0.53/1.4 |
| Comparative example 1 | -2.01/72.8 | 0.77/69.8 | 3.29/67.8 | 5.3/-5.0 |
| Comparative example 2 | -1.22/- | 4.15/- | 9.05/- | 10.27/- |
| Comparative example 3 | -2.12/73.7 | -1.85/74.5 | -1.49/75.1 | 0.58/1.4 |
| Comparative example 4 | -1.42/- | 30.24/- | 32.24/- | 33.66/- |

(Comparison between Examples 1 to 7 and Comparative example 1)

In producing the acrylic resin for the light resistant coat layer for sealing film 8 prepared in Comparative example 1, an ultraviolet absorber and a photostabilizing agent (HALS) were added in a later step to void crosslinking. When exposed to a high temperature, humid environment or ultraviolet rays, therefore, the ultraviolet absorber and the photostabilizing agent bled out from inside the coat film to the film surface to cause the film to lose ultraviolet screening capability, leading to an increase in the $\Delta$b-value and yellowing of the base film. Sealing films 1-7 prepared Examples 1-7, on the other hand, suffered little changes in film appearance as represented by the L-value and b-value under ultraviolet irradiation for a long period of time (240 hours).

(Comparison between Examples 1 to 7 and Comparative example 2)

The light resistant coat layer of sealing film 9 prepared in Comparative example 2 contained no color pigment. Though it was not impossible, therefore, to improve the film appearance or color tone, the layer showed high ultraviolet careening performance as it comprised an acrylic resin copolymerized with an ultraviolet absorber and a photostabilizing agent. However, it suffered larger changes in the b-value according to the color system than the sealing films prepared in Example 1-7 when subjected to an extended ultraviolet ray irradiation test assuming a long-term outdoor use. This suggests that the addition of a color pigment serves not only to control the color tone in the film appearance but also to improve its ultraviolet resistance as the pigment absorbs or reflects light.

(Comparison between Examples 1 to 5 and 7 and Comparative example 3)

The light resistant coat layer of sealing film 10 prepared in Comparative example 3 contained no plasticizer. Therefore, the contact strength between the base film and the coat layer was not sufficiently high from the beginning, and the moist heat resistance test and the ultraviolet ray irradiation test caused the coat film (coat layer) to further deteriorate in the strength of contact with the base film. This may be because the coat film increased in hardness after drying (production) as the white pigment (titanium oxide) was added in a larger amount than the acrylic polyol resin binder. The moist heat test and the ultraviolet ray irradiation test tends to cause further changes in the coat film exposed to heat or light energy, leading to a significant deterioration in the strength of contact with the base film. It is assumed the coat layer of the invention is designed for practical use as the outermost layer of the module, and therefore, as it is exposed for a long term to ultraviolet rays at a high temperature and high humidity, the junction box will be likely to be removed from the backside sealing sheet together with the coat layer.

(Comparison between Examples 1 to 7 and Comparative example 4)

Sealing film 11 produced in Comparative example 4 (which is actually a film of Lumiror (registered trademark) X10S free from a coat layer) does not have ultraviolet screening capability, and it is free from a resin layer containing a color pigment to adjust the color tone of the film. As a result, degradation and yellowing of the resin was caused by ultraviolet irradiation. If used as the outermost layer of a for solar battery backside sealing component, the film can suffer cracks and pinholes in extreme cases, possibly leading not only to loss of required sealing sheet characteristics including electrical insulating properties and moisture barrier properties, but also to impaired performance of the solar cell module.

(Comparison between Examples 1 to 5, and 7 and Example 6)

The light resistant coat layer of sealing film 6 prepared in Example 6 contains carbon black as color pigment. Therefore, the film has black appearance, and serves to produce a black resin film through a coating process, whereas conventionally, black resin firms have been produced by processing a kneaded composition containing a black pigment, such as carbon black, into a resin layer. In addition, not only the acrylic polyol resin has ultraviolet screening capability, but also the resin itself is resistant to ultraviolet rays, thus serving to protect the base film from ultraviolet rays. Furthermore, as in the case of the sealing films 1 to 5, and 7 prepared in Examples 1 to 5, and 7, the resin can maintain its ultraviolet screening capability adequately if kept exposed to moist heat and ultraviolet rays.

(Comparison between Examples 1 to 6 and Example 7)

The light resistant coat layer of sealing film 7 prepared in Example 7 contains a biuret-type (aliphatic) hexamethylene diisocyanate resin as curing agent. Accordingly, the coat layer cures at a lower rate than that containing a nurate-type (alicyclic) hexamethylene diisocyanate resin and tends to be lower in ethanol resistance, which is a characteristic required in the outermost layer of a sealing film, as compared with the layers prepared in Examples 1 to 6.

(Example 8)

An adhesive for dry lamination is spread with a wire bar over the opposite film surface to the coat layer side of sealing film 2 by the same procedures as in Example 2, and dried at 80°C for 45 seconds to form adhesive layer 1 of 3.5 μm. Then, a light reflective film, which is a white polyethylene terephthalate film of Lumiror (registered trademark) E20F (50 μm) supplied by Toray Industries, Inc., is bonded to adhesive layer 1 using a hand roller. Furthermore, an adhesive for dry lamination is spread with a wire bar over the opposite film surface to the light resistant coat layer side of this laminate film, and dried at 80°C for 45 seconds to form adhesive layer 2 of 3.5 μm. Elsewhere, an aluminum oxide-deposited polyethylene terephthalate film combined with a vapor barrier film (Barrier-Locks (registered trademark) 1031HGTS (12 μm) supplied by Toray Advanced Film Co., Ltd.) is prepared, and a paint for adhesive layer formation and a paint for heat-bonding resin layer formation are spread in this order with a double-head tandem type direct gravure coater to prepare a vapor barrier film. The deposited aluminum oxide layer of this vapor barrier film is brought in contact with the surface of adhesive layer 2 of the former laminate film, and they are bonded with a hand roller. This procedure is carried out to produce three films, which are combined into a sheet and aged for three days in an oven heat at 40°C to provide solar battery backside sealing component 1.

. Adhesive layer coating conditions: expected dried film thickness 0.2 μm, drying oven temperature setting 120°C
. Heat-bonding resin layer coating conditions: expected dried film thickness 1.0 μm, drying oven temperature setting 100°C
. Coating speed: 100 m/min
. Aging: aging at 40°C for 2 days after coating and winding up

(Example 9)

Except that a polyethylene film (50 μm) (supplied by Toray Advanced Film Co., Ltd.) that can develop a strong contact with EVA sheets was used instead of the vapor barrier film, the same procedure as in Example 8 was carried out to produce solar battery backside sealing component 2.

(Example 10)

Except that sealing film 6 was used instead of sealing film 2, the same procedure as in Example 8 was carried out to produce solar battery backside sealing component 3.

(Comparative example 5)

Except that sealing film 9 was used instead of sealing film 1, the same procedure as in Example 8 was carried out to produce solar battery backside sealing component 4.

(Comparative example 6)

Except that sealing film 10 was used instead of sealing film 1, the same procedure as in Example 8 was carried out to produce solar battery backside sealing component 5.

(Comparative example 7)

Except that sealing film 11 was used instead of sealing film 1, the same procedure as in Example 8 was carried out to produce solar battery backside sealing component 6.

[Table 4]

| Example No. | sheet constitution | light resistant coat layer | |
|---|---|---|---|
| | | coating liquid | coating weight [g/m$^2$] |
| Example 8 | heat-bonding resin layer/adhesive layer/Barrier-Locks 1031HGTS/adhesive layer /Lumiror E20F/ adhesive layer/Lumiror X10S/light resistant coat layer | paint 1 | 3.2 |
| Example 9 | polyethylene film/adhesive layer/Lumiror E20F/ adhesive layer /Lumiror X10S/light resistant coat layer | paint 1 | 3.2 |
| Example 10 | heat-bonding resin layer/adhesive layer/Barrier-Locks 1031HGTS/adhesive layer /Lumiror E20F/ adhesive layer/Lumiror X10S/light resistant coat layer | paint 5 | 3.2 |
| Comparative example 5 | heat-bonding resin layer/adhesive layer/Barrier-Locks 1031 HGTS/adhesive layer /Lumiror E20F/ adhesive layer/Lumiror X10S/light resistant coat layer | paint 8 | 3.2 |
| Comparative example 6 | heat-bonding resin layer/adhesive layer/Barrier-Locks 1031 HGTS/adhesive layer /Lumiror E20F/ adhesive layer/Lumiror X10S/light resistant coat layer | paint 9 | 3.2 |
| Comparative example 7 | heat-bonding resin layer/adhesive layerBarrier-Locks 1031HGTS/adhesive layer /Lumiror E20F/ adhesive layer/Lumiror X10S | - | - |

[Table 5]

| Example No. | EVA sheet contact strength | vapor transmittance (40°C, 90%RH) | ultraviolet resistance of outermost layer | silicone resin adhesiveness to junction box |
|---|---|---|---|---|
| | [N/50mm] | [g/m$^2$.day] | $\Delta b$ | [N/10mm] |
| Example 8 | 390 | 0.4 | 0.53 | 42 |
| Example 9 | 490 | 1.4 | 0.54 | 42 |
| Example 10 | 390 | 0.4 | -0.62 | 40 |

(continued)

| Example No. | EVA sheet contact strength | vapor transmittance (40°C, 90%RH) | ultraviolet resistance of outermost layer | silicone resin adhesiveness to junction box |
|---|---|---|---|---|
| | [N/50mm] | [g/m²·day] | Δb | [N/10mm] |
| Comparative example 5 | 390 | 0.4 | 10.27 | 40 |
| Comparative example 6 | 390 | 0.4 | 0.58 | 5 |
| Comparative example 7 | 390 | 0.4 | 33.71 | 40 |

(Comparison between Examples 8 to 10 and Comparative example 5)

Solar battery backside sealing components 1 to 3 produced by the procedure described in Examples 8 to 10 are all free from deterioration in the contact strength between the base film and the coating layer when ultraviolet rays are applied to light resistant coat layer, i.e. the outmost layer in the solar battery module structure, and both the layer and the base film yellow only slightly. They are high in the strength of contact with fillers (EVA), which is a characteristic required in the solar battery backside sealing component, and sealing components 1 and 3, which contain a gas barrier film in its constitution, have good moisture barrier properties. In the case of solar battery backside sealing component 4 prepared by the procedure described in Comparative example 5, on the other hand, the light resistant coat layer, i.e. the outermost layer, contains no color pigment and cannot make the wiring pattern in the module invisible, and accordingly, the sealing component suffers some change in the color tone in its appearance (represented by Δb) when irradiated with ultraviolet rays. It is expected, therefore, ultraviolet rays will finally reach the base film layer located in the inner position in the light resistant coat layer as component is exposed to ultraviolet rays for an extended period of time, possibly leading to gradual degradation of the resin.

(Comparison between Examples 8 to 10 and Comparative example 6)

In the case of solar battery backside sealing component 5 prepared by the procedure described in Comparative example 6, the light resistant coat layer, i.e. the outermost layer, contains no plasticizer, and the contact strength between the base film and the light resistant coat layer, located outermost in the sealing component, is slightly insufficient at the initial point. The contact becomes inferior when subjected to moist heat test or ultraviolet ray irradiation test. With such coat layer characteristics, this sealing component is largely inferior in adhesive strength to silicone resin as compared with sealing component 6 in which Lumiror X10S film, which has been proved to have practically adequate characteristics, is located outmost in the component which does not have a coat layer. In view of the fact that the contact strength between the base film and the light resistant coat layer decreases as they are subjected to moist heat test or ultraviolet ray irradiation test, the adhesive strength to the silicone resin, i.e. the terminal box, will decrease as it is exposed to outdoor environment, possibly causing, in an extreme case, the terminal box to be removed together with the coat layer.

(Comparison between Examples 8 to 10 and Comparative example 7)

Solar battery backside sealing component 6 prepared by the procedure described in Comparative example 7 does not have a light resistant coat layer as its outermost layer. Thus, it does not contain an ultraviolet ray screening coat layer and it is not ultraviolet resistant at all. Therefore, it cannot be used as backside sealing component of a solar battery module such as of field installation type that is expected to installed in a location where it is exposed to ultraviolet rays reflected from the ground surface and the like.

As clearly seen from the comparisons between Examples and Comparative examples described above, the invention serves to produce a film for solar battery backside sealing component comprising a pigmented layer that has high light resistance and moist heat resistance to serve for long term use in a harsh outdoor environment, as well as good decorative properties and high adhesion strength to silicone resin for bonding to terminal boxes which is a characteristic required when used as outermost layer.

According to a preferred embodiment of the invention, it is possible to produce a solar battery backside sealing component that develops a strong contact with a silicon cell filler layer, has high light reflectance, enhances the performance of a solar cell module, and maintains the performance for a long period of time.

Industrial applicability

The solar battery backside sealing sheet of the invention not only has high light resistance and moist heat resistance but also has good decorative appearance and a high strength of contact with silicone resin for bonding to a terminal box, which is a characteristic required when used as the outmost layer, and therefore, it can work effectively in solar cell modules, indicating the usefulness of the solar battery backside sealing sheet of the invention and solar cell modules made thereof.

**Claims**

1.   A film for solar battery backside sealing component comprising a resin layer containing a resin produced by copolymerizing an acrylic polyol resin, an ultraviolet absorber, and a photostabilizing agent, the resin layer further comprising a color pigment and a plasticizer,wherein the resin layer is laminated to at least one side of a base film.

2.   A film for solar battery backside sealing component as claimed in claim 1 wherein said plasticizer is at least one selected from the group of polyester plasticizer, epoxy plasticizer, and phthalic acid ester plasticizer.

3.   A film for solar battery backside sealing component as claimed in either claim 1 or 2 wherein said resin layer contains polyisocyanate resin.

4.   A film for solar battery backside sealing component as claimed in claim 3 wherein said polyisocyanate resin is at least one selected from the group of aliphatic isocyanate resin, alicyclic isocyanate resin, and araliphatic isocyanate resin.

5.   A film for solar battery backside sealing component as claimed in claim 1 wherein said color pigment is titanium oxide.

6.   A solar battery backside sealing component comprising at least a film selected from the group of white film, film with a deposited inorganic oxide layer, and film that can be heat-bonded to a vinyl acetate copolymer, laminated to the opposite side to the resin layer side of a film for solar battery backside sealing component as claimed in claim 1.

7.   A solar cell module wherein its silicon cell filler layer side is bonded to the opposite side to said resin layer side of a solar battery backside sealing component as claimed in claim 6.

**Patentansprüche**

1.   Folie für ein Solarbatterierückseiten-Dichtungselement, umfassend eine Harzschicht mit einem Harz, das durch Copolymerisieren eines Acrylpolyol-Harzes, eines Ultraviolet-Absorbers und eines Fotostablisierungsmittels hergestellt ist, wobei die Harzschicht ferner ein Farbpigment und einen Weichmacher aufweist, wobei die Harzschicht auf zumindest eine Seite einer Basisfolie laminiert ist.

2.   Folie für ein Solarbatterierückseiten-Dichtungselement nach Anspruch 1, wobei der Weichmacher zumindest einer ist, der aus der Gruppe von Polyester-Weichmachern, Epoxy-Weichmachern und Phthalsäureester-Weichmachern gewählt ist.

3.   Folie für ein Solarbatterierückseiten-Dichtungselement nach Anspruch 1 oder 2, wobei die Harzschicht ein Polyisocyanatharz enthält.

4.   Folie für ein Solarbatterierückseiten-Dichtungselement nach Anspruch 3, wobei das Polyisocyanatharz zumindest eines ist, das aus der Gruppe eines aliphatisches Isocyanatharzes, alicyclischen Isocyanatharzes und eines araliphatischen Isocyanatharzes gewählt ist.

5.   Folie für ein Solarbatterierückseiten-Dichtungselement nach Anspruch 1, wobei das Farbpigment Titanoxid ist.

6.   Folie für ein Solarbatterierückseiten-Dichtungselement, das zumindest eine Folie aufweist die aus der Gruppe einer weißen Folie, einer Folie mit einer aufgebrachten anorganischen Oxidschicht und einer Folie gewählt ist, die auf ein Vinylacetat-Copolymer heißverklebt werden kann, die auf die gegenüberliegende Seite der Harzschichtseite einer Folie für ein Solarbatterierückseiten-Dichtungselement nach Anspruch 1 laminieret ist.

7. Solarzellenmodul, wobei dessen Siliziumzellen-Füllschichtseite auf die gegenüberliegende Seite der Harzschichtseite eines Solarbatterierückseiten-Dichtungselements nach Anspruch 6 geklebt ist.

**Revendications**

1. Film pour composant d'étanchéité de face arrière de batterie solaire comprenant une couche de résine contenant une résine produite par copolymérisation d'une résine de polyol acrylique, un absorbeur d'ultraviolet et un agent photostabilisant, la couche de résine comprenant en outre un pigment de couleur et un plastifiant, dans lequel la couche de résine est stratifiée à au moins un côté d'un film de base.

2. Film pour composant d'étanchéité de face arrière de batterie solaire selon la revendication 1, dans lequel ledit plastifiant est au moins un plastifiant choisi dans le groupe constitué d'un plastifiant poly(ester), d'un plastifiant époxy et d'un plastifiant ester d'acide phtalique.

3. Film pour composant d'étanchéité de face arrière de batterie solaire selon l'une ou l'autre des revendications 1 et 2, dans lequel ladite couche de résine contient de la résine de poly(isocyanate).

4. Film pour composant d'étanchéité de face arrière de batterie solaire selon la revendication 3, dans lequel ladite résine de poly(isocyanate) est au moins une résine choisie dans le groupe constitué d'une résine d'isocyanate aliphatique, d'une résine d'isocyanate alicylique et d'une résine d'isocyanate araliphatique.

5. Film pour composant d'étanchéité de face arrière de batterie solaire selon la revendication 1, dans lequel ledit pigment de couleur est l'oxyde de titane.

6. Composant d'étanchéité de face arrière de batterie solaire comprenant au moins un film choisi dans le groupe constitué d'un film blanc, d'un film sur lequel est déposée une couche d'oxyde inorganique ; et d'un film qui peut être assemblé à la chaleur à un copolymère d'acétate de vinyle, stratifié au côté opposé au côté couche de résine d'un film pour un composant d'étanchéité de face arrière de batterie solaire selon la revendication 1.

7. Module de cellule solaire, dans lequel son côté couche de remplissage de cellule de silicium est assemblé au côté opposé audit côté couche de résine d'un composant d'étanchéité de face arrière de batterie solaire selon la revendication 6.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005015557 A
- JP HEI11291432 B
- JP 2002090515 A